(19) Europäisches Patentamt / European Patent Office / Office européen des brevets

(11) **EP 4 711 787 A1**

(12) **EUROPEAN PATENT APPLICATION**

(43) Date of publication:
**18.03.2026 Bulletin 2026/12**

(21) Application number: **25201423.8**

(22) Date of filing: **10.09.2025**

(51) International Patent Classification (IPC):
**G01R 31/392** *(2019.01)*    G01R 31/367 *(2019.01)*

(52) Cooperative Patent Classification (CPC):
**G01R 31/392;** G01R 31/367

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **13.09.2024 KR 20240125912**

(71) Applicant: SAMSUNG SDI CO., LTD.
**Yongin-si, Gyeonggi-do 17084 (KR)**

(72) Inventors:
• **JANG, Junho**
**17084 Yongin-si (KR)**
• **KIM, Haemin**
**17084 Yongin-Si (KR)**
• **LEE, Dongryul**
**17084 Yongin-Si (KR)**
• **KO, Younghoon**
**17084 Yongin-si (KR)**
• **YI, Sangkoan**
**17084 Yongin-si (KR)**
• **LEE, Yujin**
**17084 Yongin-Si (KR)**
• **KWON, Youngwoong**
**17084 Yongin-Si (KR)**

(74) Representative: **Maiwald GmbH**
**Elisenhof**
**Elisenstraße 3**
**80335 München (DE)**

(54) **DEVICE AND METHOD FOR PREDICTING A LIFE OF BATTERY**

(57)    The present disclosure relates to a method of predicting a life of a battery, including calculating cumulative slippage data based on life assessment data of a target battery, calculating a correlation between the cumulative slippage and a performance life of the target battery, and predicting a life of the target battery based on the correlation.

16

FIG. 3

EP 4 711 787 A1

## Description

## BACKGROUND

## FIELD

Aspects of embodiments of the present disclosure relate to a device and method for predicting the life of a battery.

## DESCRIPTION OF THE RELATED ART

When developing a battery or secondary battery, charging and discharging can be performed repetitively under conditions and for a time similar to the actual usage environment of the battery so that the life of the battery is guaranteed. In this way, by having the life of a battery (or the residual rate of charge capacity) measured, the long-term life of the battery can be predicted and the life of the battery can be assessed at the same time. However, this method of assessing the life of a battery has a problem of taking a long time and being cumbersome. Accordingly, it is desirable to provide a method for predicting the life of a battery, which can shorten the time for assessing the life of the battery and detect the failure of the battery at an early stage.

The above information disclosed in this Background section is for enhancement of understanding of the background of the present disclosure, and therefore, it may contain information that does not constitute related (or prior) art.

## SUMMARY

A problem to be solved by the present disclosure is to provide a device for predicting the life of a battery and a method of operating the same for solving the above problems.

These and other aspects and features of the present disclosure will be described in or will be apparent from the following description of embodiments of the present disclosure.

In order to solve the technical problems above, a method of predicting a life of a battery in accordance with an aspect of the present disclosure may include calculating cumulative slippage data based on life assessment data of a target battery, calculating a correlation between the cumulative slippage and a performance life of the target battery, and predicting a life of the target battery based on the correlation.

According to some embodiments, the life assessment data may include voltage profile data on a capacity of the target battery in a range of 0 to 250 charge/discharge cycles.

According to some embodiments, the calculating the cumulative slippage data may include calculating cumulative capacity profile (CCP) data based on the life assessment data, and calculating the cumulative slippage based on the cumulative capacity profile (CCP) data.

According to some embodiments, the calculating the cumulative capacity profile (CCP) data may include calculating the cumulative capacity profile (CCP) data based on a plurality of charge profiles and a plurality of discharge profiles extracted from the life assessment data.

According to some embodiments, each of the plurality of charge profiles may be a voltage profile corresponding to the capacity of the target battery for a single charge cycle, and each of the plurality of discharge profiles may be a voltage profile corresponding to the capacity of the target battery for a single discharge cycle.

According to some embodiments, the calculating the cumulative slippage may include calculating a plurality of charge slippages and a plurality of discharge slippages based on the cumulative capacity profile (CCP) data, and calculating the cumulative slippage based on the plurality of charge slippages and the plurality of discharge slippages.

According to some embodiments, the cumulative slippage may be a sum of difference values between each of the plurality of charge slippages and each of the plurality of discharge slippages.

According to some embodiments, each of the plurality of charge slippages may be an amount of change between a charge profile of a first charge cycle and a charge profile of a subsequent cycle of the first charge cycle, and each of the plurality of discharge slippages may be an amount of change between a discharge profile of a first discharge cycle and a discharge profile of a subsequent cycle of the first discharge cycle.

According to some embodiments, the calculating the correlation may include calculating a correlation between the cumulative slippage and a deterioration tendency of the target battery.

According to some embodiments, the calculating the correlation may include calculating a correlation between the cumulative slippage and a performance life of the target battery using a linear regression model technique.

According to some embodiments, the predicting the life of the target battery may include predicting a state of health (SOH) of the target battery based on charge and discharge cycles based on the cumulative slippage.

In order to solve the technical problems above, a device for predicting a life of a battery in accordance with an aspect of the present disclosure may include a data generation module configured to generate cumulative slippage data based on life assessment data of a target battery, a slippage life analysis module configured to calculate a correlation between the cumulative slippage and a performance life of the target battery, and a life prediction module configured to predict a life of the target battery based on the correlation.

According to some embodiments, the life assessment data may include voltage profile data on a capacity of the target battery in a range of 0 to 250 charge/discharge cycles.

According to some embodiments, the data generation module may include a CCP calculation module configured to calculate cumulative capacity profile (CCP) data based on the life assessment data, and a slippage calculation module configured to calculate a cumulative slippage based on the cumulative capacity profile (CCP) data.

According to some embodiments, the CCP calculation module may be configured to calculate the cumulative capacity profile (CCP) data based on a plurality of charge profiles and a plurality of discharge profiles extracted from the life assessment data.

Preferably, the slippage calculation module may be configured to calculate a plurality of charge slippages and a plurality of discharge slippages based on the cumulative capacity profile (CCP) data.

Preferably, the slippage calculation module may be configured to calculate the cumulative slippage based on the plurality of charge slippages and the plurality of discharge slippages.

Preferably, the slippage life analysis module may be configured to calculate a correlation between the cumulative slippage and a deterioration tendency of the target battery.

Preferably, the slippage life analysis module may be configured to calculate a correlation between the cumulative slippage and a performance life of the target battery using a linear regression model technique.

Preferably, the life prediction module may be configured to predict a state of health (SOH) of the target battery based on charge and discharge cycles based on the cumulative slippage.

According to some embodiments of the present disclosure, the long-term life of a battery can be easily predicted based on the charge and discharge data for the initial life data of the battery.

According to some embodiments of the present disclosure, the efficiency of battery manufacturing can be improved as the life of the battery can be predicted at an early stage.

However, aspects and features of the present disclosure are not limited to those described above, and other aspects and features not mentioned will be clearly understood by a person skilled in the art from the detailed description, described below.

## BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:

FIG. 1 is a block diagram describing a battery life assessment system including a battery life prediction device according to some embodiments of the present disclosure.

FIG. 2 is a block diagram showing an information processing system used in the battery life assessment system according to some embodiments of the present disclosure.

FIG. 3 is a block diagram describing the battery life prediction device according to some embodiments of the present disclosure.

FIG. 4 is a block diagram describing the configuration of the data generation module according to some embodiments of the present disclosure.

FIGS. 5 and 6 are examples describing the operation of a CCP calculation module according to some embodiments of the present disclosure.

FIGS. 7a and 7b are examples describing the operation of a slippage calculation module.

FIGS. 8 and 9 are examples describing the operation of the slippage life analysis module according to some embodiments of the present disclosure.

FIG. 10 is a flowchart describing a life prediction method for a battery according to some embodiments.

## DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

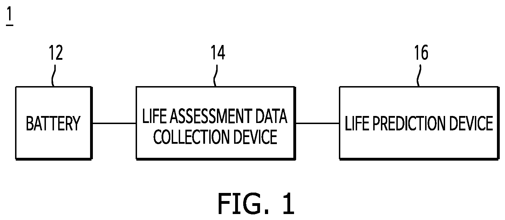

FIG. 1 is a block diagram describing a battery life assessment system 1 including a battery life prediction device 16 according to some embodiments of the present disclosure.

Referring to FIG. 1, the life assessment system 1 may include a battery 12, a life assessment data collection device 14, and a life prediction device 16.

In some embodiments, the life assessment data collection device 14 may collect life assessment data of a target battery 12 from a manufacturing facility that manufactures target battery 12 cells. For example, the life assessment data collection device 14 may collect life assessment data generated while repetitively performing charging and discharging on the target battery 12 cells by the manufacturing facility. Here, the life assessment data may include voltage profile data on the charge capacity of the target battery 12. As a specific example, the life assessment data may be voltage profile data of the target battery 12 in the range of 0 to 250 charge/discharge cycles. In other embodiments, the life assessment data collection device 14 may include a charge/discharge module capable of performing charging/discharging on the target battery 12 manufactured by the manufacturing facility, and a data collection module that collects life assessment data generated while repetitively performing charging and discharging on the target battery 12 cells by the charge/discharge module.

The life prediction device 16 may calculate slippage-related data based on the life assessment data. Here, the slippage may refer to the amount of change in capacity in the cumulative capacity-voltage profile data. For example, a charge slippage may refer to the amount of change in charge capacity in the cumulative capacity-voltage profile data, and a discharge slippage may refer to the amount of change in discharge capacity in the cumulative capacity-voltage profile data.

In some embodiments, the life prediction device 16 may predict the life of the target battery 12 based on the slippage-related data. Here, the life prediction device 16 may predict the life of the target battery 12 based on the correlation between the slippage-related data including the cumulative slippage and the deterioration tendency of the target battery 12. For example, the deterioration tendency may include, but is not limited to, a point of a sudden decline and a point of EOL (end of life) of the target battery 12. The deterioration tendency may include all characteristics indicative of a deterioration tendency according to the life of the target battery 12.

The correlation between the cumulative slippage and the performance life of the target battery 12 may be calculated using a linear regression model technique. Further, the life prediction device 16 may predict the state of health (SOH) of the target battery 12 according to the charge/discharge cycle based on the correlation. The life predicted by the life prediction device 16 may be used to assess the life quality of the target battery 12.

As described above, the battery life assessment system 1 according to some embodiments of the present disclosure can easily predict the long-term life of a battery based on the initial life data of the battery.

According to some embodiments of the present disclosure, as the battery life assessment system 1 can predict the life of the battery, the quality of the battery cells can be assessed at an early stage, and the efficiency of battery manufacturing can be improved.

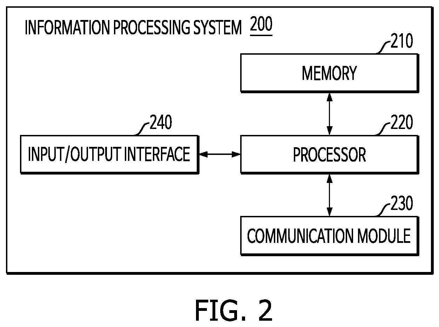

FIG. 2 is a block diagram showing an information processing system 200 used in the battery life assessment system 1 according to some embodiments of the present disclosure.

Referring to FIG. 2, the information processing system 200 may correspond to at least one or more of the battery life assessment system 1 and the life prediction device 16 shown in FIG. 1, for example. The information processing system 200 may include a memory 210, a processor 220, a communication module 230, and an input/output interface 240. Referring to FIG. 2, the information processing system 200 may be configured to be able to communicate information and/or data over a network using the communication module 230. In some embodiments, the information processing system 200 may be formed of at least one device including the memory 210, the processor 220, the communication module 230, and the input/output interface 240.

The memory 210 may include any non-transitory computer-readable recording medium. In some embodiments, the memory 210 may include a permanent mass storage device, such as read-only memory (ROM), a disk drive, a solid-state drive (SSDs), flash memory, etc. As another example, the permanent mass storage device, such as ROM, SSD, flash memory, a disk drive, etc., may be included in the information processing system 200 as a separate persistent storage device distinct from the memory 210. Further, the memory 210 may store software components including an operating system and at least one program code (e.g., code for implementing a slippage life analysis module and a life prediction module installed and run in the information processing system 200).

These software components may be loaded from a computer-readable recording medium separate from the memory 210. Such a separate computer-readable recording medium may include a recording medium directly connectable to the information processing system 200, and may include, for example, computer-readable recording media such as floppy drives, disks, tapes, DVD/CD-ROM drives, memory cards, etc. As another example, the software components may be loaded into the memory 210 via the communication module 230 rather than computer-readable recording media. For example, at least one program may be loaded onto the memory 210 based on a computer program (e.g., programs for implementing a slippage life analysis module and a life prediction module, etc.) installed by files provided via the communication module 230 by developers or a file distribution system that distributes installation files of an application.

The processor 220 may be configured to process commands of computer programs by performing basic arithmetic, logic, and input/output operations. The commands may be provided to a user terminal (not shown) or another external system by the memory 210 or the communication module 230. For example, the processor 220 may collect life assessment data of the target battery from one or more manufacturing facilities, generate cumulative slippage data based on the life assessment data, calculate a correlation between the cumulative slippage and the performance life of the target battery, and then predict the life of the target battery based on the correlation.

The communication module 230 may provide a configuration or function for the user terminal (not shown) and the information processing system 200 to communicate with each other via a network, and may provide a configuration or function for the information processing system 200 to communicate with an external system (as one example, a manufacturing facility for the target battery, a separate cloud system, etc.). In some embodiments, control signals, commands, data, etc., provided under the control of the processor 220 of the information processing system 200 may be transmitted to the user terminal and/or the external system by way of the communication module 230 and the network via the communication module of the user terminal and/or the external system. For example, the predicted life information of the target battery, etc., generated by the information processing system 200 may be transmitted to the user terminal and/or the external system by way of the communication module 230 and the network via the communication module of the user terminal and/or the external system. Further, the user terminal and/or the external system that has received the predicted battery life information may output the received information via a display output-capable device.

Moreover, the input/output interface 240 of the information processing system 200 may be a means for interfacing with devices (not shown) for input or output that may be connected to the information processing system 200 or that the information processing system 200 may include. In FIG. 2, the input/output interface 240 is shown as an element configured separately from the processor 220 but is not limited thereto, and the input/output interface 240 may be configured to be included in the processor 220. The information processing system 200 may include more components than those in FIG. 2. However, there is no need to explicitly show most of the prior art components.

The processor 220 of the information processing system 200 may be configured to manage, process, and/or store information and/or data received from a plurality of user terminals and/or a plurality of external systems. According to some embodiments, the processor 220 may receive the life assessment data of the target battery, etc., from the user terminal and/or the external system. The processor 220 may calculate a cumulative slippage based on the life assessment data of the target battery, predict the life of the target battery based on the calculated cumulative slippage, and then output the corresponding life prediction information, etc., via a display output-capable device connected to the information processing system 200.

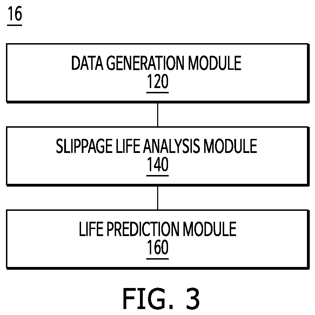

FIG. 3 is a block diagram describing the battery life prediction device 16 according to some embodiments of the present disclosure.

Referring to FIG. 3, the life prediction device 16 may include a data generation module 120, a slippage life analysis module 140, and a life prediction module 160.

In some embodiments, the data generation module 120 may generate cumulative slippage data based on the life assessment data of the target battery. Here, the cumulative slippage may be calculated based on cumulative capacity profile (CCP) data. The cumulative capacity profile (CCP) data may be data obtained by accumulating a plurality of charge capacity-voltage profiles and a plurality of discharge capacity-voltage profiles.

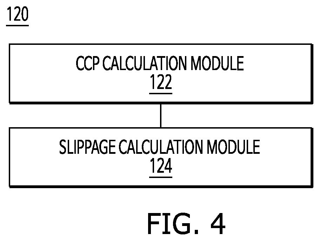

The specific configuration of the data generation module 120 will be described in detail in FIGS. 4 to 7b.

In some embodiments, the slippage life analysis module 140 may calculate a correlation between the cumulative slippage and the deterioration tendency of the target battery. Here, the deterioration tendency may include a point of a sudden decline and a point of EOL (end of life) of the target battery 12. The point of a sudden decline may refer to a cycle point at which the slope of the state of health (SOH) for the target battery decreases rapidly due to rapid deterioration of the target battery, etc. Based on the correlation described above, the slippage life analysis module 140 may calculate the correlation between the cumulative slippage and the performance life of the target battery.

In some embodiments, the slippage life analysis module 140 may calculate a correlation between the cumulative slippage and the performance life of the target battery using a linear regression model technique. However, the present disclosure is not limited thereto. For example, the performance life of the target battery may be included in the life assessment data of the corresponding battery. Here, the performance life may refer to a life cycle when the state of health (SOH) of the target battery is between 85% and 75%. Preferably, the performance life may be, but is not limited to, a life cycle when the state of health (SOH) of the target battery is 80%. Here, the point at which the state of health (SOH) of the battery is 80% may be an EOL point of the battery.

In some embodiments, the cumulative slippage may be calculated from the accumulated charge slippage and discharge slippage when the life cycle of the target battery is in the range of 0 to 250. Preferably, the cumulative slippage may be calculated in the range of 0 to 100 life cycles of the target battery. However, the present disclosure is not limited thereto.

In some embodiments, the cumulative slippage may have linearity with respect to the performance life, and the slippage life analysis module 140 may calculate a correlation having such linearity. Accordingly, the slippage life analysis module 140 may calculate a performance life or state of health corresponding to a particular cumulative slippage of the target battery based on the correlation having such linearity.

In some embodiments, the slippage life analysis module 140 may calculate a correlation according to a linear regression model in advance based on data on the cumulative slippage and performance life of a plurality of batteries. Then, the slippage life analysis module 140 may store the correlation calculated in advance, and calculate a correlation between the cumulative slippage and the performance life of the target battery based thereon. In some embodiments, the life prediction module 160 may predict the state of health (SOH) of the target battery according to the charge/discharge cycle based on the correlation between the cumulative slippage and the performance life calculated by the slippage life analysis module 140.

As described above, the battery life assessment system 1 according to some embodiments of the present disclosure can easily predict the long-term life of a battery based on the cumulative slippage, which is the initial life data of the battery.

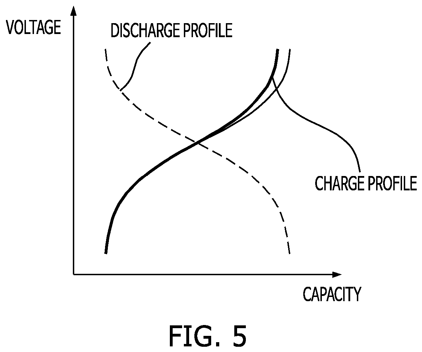

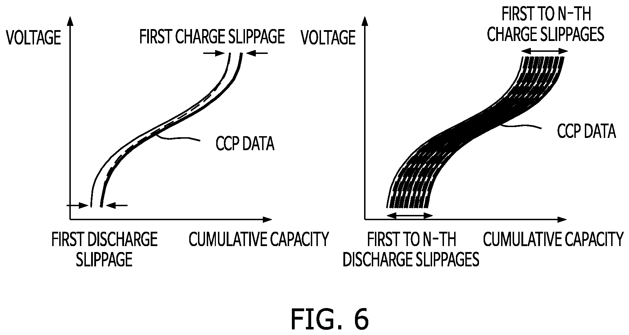

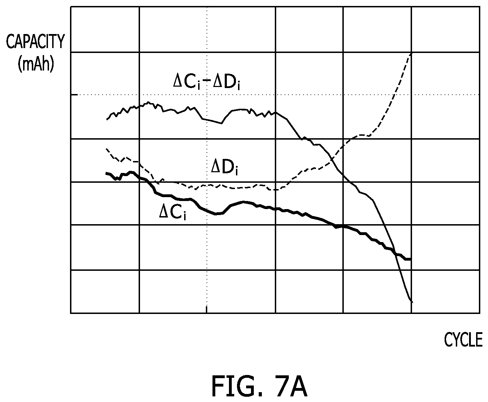

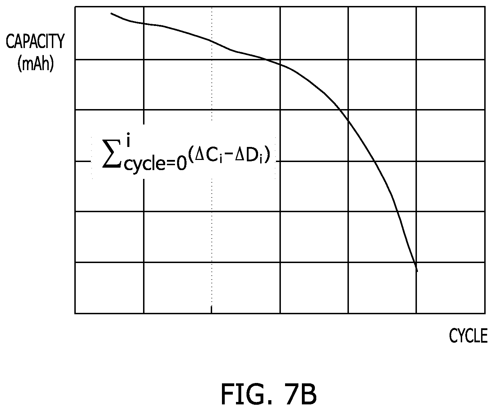

FIG. 4 is a block diagram describing the configuration of the data generation module 120 according to some embodiments of the present disclosure. FIGS. 5 and 6 are examples describing the operation of a CCP calculation module 122 according to some embodiments of the present disclosure, and FIGS. 7a and 7b are examples describing the operation of a slippage calculation module 124.

Referring to FIG. 4, the data generation module 120 may include the CCP calculation module 122 and the slippage calculation module 124.

In some embodiments, the CCP calculation module 122 may calculate cumulative capacity profile (CCP) data based on the life assessment data. For example, referring to FIG. 5, a plurality of charge profiles and discharge profiles showing changes in charge and discharge voltages according to changes in the charge capacity of the target battery may be measured. Of these, each of the plurality of charge profiles may be a voltage profile according to the capacity of the target battery for one charge cycle. Further, each of the plurality of discharge profiles may be a voltage profile according to the capacity of the target battery for one discharge cycle.

Referring to FIG. 6, the CCP calculation module 122 may calculate cumulative capacity profile (CCP) data based on the plurality of charge profiles and the plurality of discharge profiles extracted from the life assessment data. Further, the slippage calculation module 124 may calculate a cumulative slippage based on the cumulative capacity profile (CCP) data.

In some embodiments, the slippage calculation module 124 may calculate a plurality of charge slippages and a plurality of discharge slippages based on the cumulative capacity profile (CCP) data. Referring to FIGS. 7a and 7b, each of the plurality of charge slippages may be the amount of change between the charge profile of a first charge cycle and the charge profile of a subsequent cycle of the first charge cycle. That is, the i-th charge slippage $\Delta C_i$ may be the amount of change between the (i+1)th charge profile $C_i$ +1 and the i-th charge profile $C_i$. Further, each of the plurality of discharge slippages may be the amount of change between the discharge profile of a first discharge cycle and the discharge profile of a subsequent cycle of the first discharge cycle. That is, the i-th discharge slippage $\Delta D_i$ may be the amount of change between the (i+1)th discharge profile $D_i$ +1 and the i-th discharge profile $D_i$.

The slippage calculation module 124 may calculate the cumulative slippage based on the plurality of charge slippages $\Delta C$ and the plurality of discharge slippages $\Delta D$. Here, the cumulative slippage may be the sum of the difference values $\Delta C$-$\Delta D$ between each of the plurality of charge slippages $\Delta C$ and each of the plurality of discharge slippages $\Delta D$. That is, the cumulative slippage may be expressed as

$$\sum_{cycle=0}^{i}(\Delta C_i - \Delta D_i) .$$

In some embodiments, the slippage calculation module 124 may utilize the life assessment data when the life cycle of the target battery is in the range of 0 to 250. Accordingly, the slippage calculation module 124 may calculate the cumulative slippage in the range of life cycles from 0 to 250.

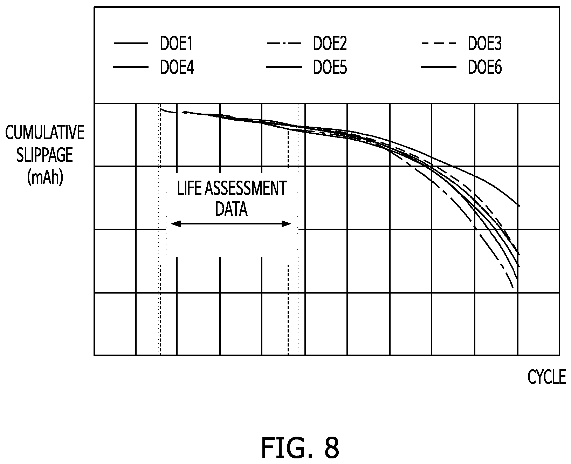

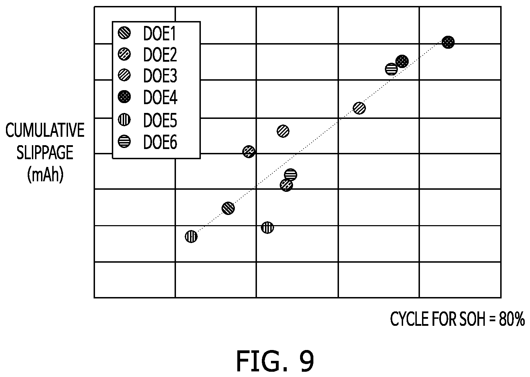

FIGS. 8 and 9 are examples describing the operation of the slippage life analysis module 140 according to some embodiments of the present disclosure.

Referring to FIG. 8, the data generation module 120 may calculate a cumulative slippage according to a predetermined life cycle of the target battery. Here, the predetermined life cycle may be 70 to 250 cycles, which is the range of the initial life cycle of the target battery. In this case, the cumulative slippage may be calculated based on the initial life data of the target battery. FIG. 8 shows a plurality of design of experiments (DOE), and each design of experiment (DOE) represents a cumulative slippage calculated for the life assessment data in the range of 70 to 250 life cycles of different experimental batteries. The data generation module 120 may transfer the cumulative slippage thus calculated to the slippage life analysis module 140. Further, the slippage life analysis module 140 may receive the life assessment data, and the slippage life analysis module 140 may extract a performance life from the life assessment data. Here, the performance life may be a life cycle when the state of health (SOH) of the target battery is 80%. Moreover, the point at which the state of health (SOH) of the target battery is 80% may be an EOL point of the target battery.

Referring to FIG. 9, the slippage life analysis module 140 may calculate a correlation between the cumulative slippage and the performance life. FIG. 9 shows the correlation calculated by the slippage life analysis module 140 based on the linearity between the cumulative slippage and the performance life calculated for a plurality of experimental data DOE1 to DOE6. Here, the performance life may be a life cycle when the state of health (SOH) is 80%. However, the performance life is merely one example and is not limited thereto. Then, the slippage life analysis module 140 may transfer the correlation between the calculated cumulative slippage and the performance life to the life prediction module 160. Then, the life prediction module 160 may predict the state of health (SOH) according to the charge/discharge cycle of the target battery based on the correlation between the cumulative slippage and the performance life calculated by the slippage life analysis module 140.

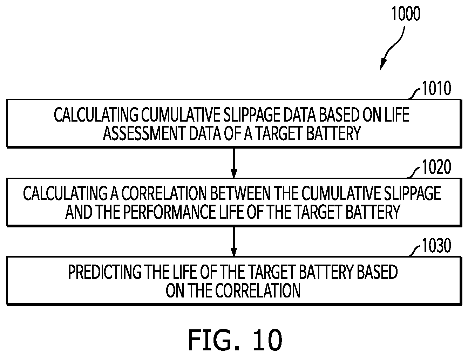

FIG. 10 is a flowchart describing a life prediction method 1000 for a battery according to some embodiments.

Referring to FIG. 10, the life prediction method 1000 may be executed by the life prediction device 16 of FIG. 3. Accordingly, specific details that overlap with what has been described in FIG. 3 will be omitted for convenience of description.

The life prediction method 1000 may begin with calculating 1010 cumulative slippage data based on life assessment data of a target battery. For example, the data generation module 120 of FIG. 3 may calculate cumulative slippage data based on the life assessment data of the target battery. Here, the life assessment data may include voltage profile data on the capacity of the target battery in the range of 0 to 250 charge/discharge cycles.

According to some embodiments, the calculating 1010 the cumulative slippage data may include calculating cumulative capacity profile (CCP) data based on the life assessment data, and calculating a cumulative slippage based on the cumulative capacity profile (CCP) data. Further, the calculating the cumulative capacity profile (CCP) data may include calculating the cumulative capacity profile (CCP) data based on a plurality of charge profiles and a plurality of discharge profiles extracted from the life assessment data. Moreover, the calculating the cumulative slippage may include calculating a plurality of charge slippages and a plurality of discharge slippages based on the cumulative capacity profile (CCP) data, and calculating the cumulative slippage based on the plurality of charge slippages and the plurality of discharge slippages.

Then, a correlation between the cumulative slippage and the performance life of the target battery may be calculated 1020. For example, the slippage life analysis module 140 of FIG. 3 may calculate the correlation between the cumulative slippage and the performance life.

According to some embodiments, the calculating 1020 the correlation may include calculating a correlation between the cumulative slippage and a deterioration tendency of the target battery. In other embodiments, the calculating 1020 the correlation may include calculating a correlation between the cumulative slippage and the performance life of the target battery using a linear regression model technique.

Accordingly, the life of the target battery may be predicted 1030 based on the correlation. For example, the life prediction module 160 of FIG. 3 may predict the life of the target battery based on the calculated correlation.

According to some embodiments, the predicting 1030 the life of the target battery may include predicting a state of health (SOH) of the target battery according to the charge/discharge cycle based on the cumulative slippage.

Although the present disclosure has been described with reference to embodiments and drawings illustrating aspects thereof, the present disclosure is not limited thereto.

## DESCRIPTION OF SOME REFERENCE SYMBOLS

1: Battery life assessment system
12: Battery
14: Life assessment data collection device
16: Life prediction device
120: Data generation module
122: CCP calculation module
124: Slippage calculation module
140: Slippage life analysis module
160: Life prediction module
200: Information processing system
210: Memory
220: Processor
230: Communication module
240: Input/output interface

## Claims

1. A method (1000) of predicting a life of a battery, comprising:

   calculating (1010) cumulative slippage data based on life assessment data of a target battery (12);
   calculating (1020) a correlation between the cumulative slippage and a performance life of the target battery (12); and
   predicting (1030) a life of the target battery (12) based on the correlation.

2. The method as claimed in claim 1, wherein the life assessment data comprises voltage profile data on a capacity of the target battery (12) in a range of 0 to 250 charge/discharge cycles.

**3.** The method as claimed in claim 1 or 2, wherein the calculating (1010) the cumulative slippage data comprises:

calculating cumulative capacity profile, CCP, data based on the life assessment data; and calculating the cumulative slippage based on the CCP data.

**4.** The method as claimed in claim 3, wherein the calculating the CCP data comprises:
calculating the CCP data based on a plurality of charge profiles and a plurality of discharge profiles extracted from the life assessment data.

**5.** The method as claimed in claim 4, wherein each of the plurality of charge profiles is a voltage profile corresponding to the capacity of the target battery (12) for a single charge cycle, and
each of the plurality of discharge profiles is a voltage profile corresponding to the capacity of the target battery (12) for a single discharge cycle.

**6.** The method as claimed in any one of the claims 3 to 5, wherein the calculating the cumulative slippage comprises:

calculating a plurality of charge slippages and a plurality of discharge slippages based on the CCP data; and
calculating the cumulative slippage based on the plurality of charge slippages and the plurality of discharge slippages.

**7.** The method as claimed in any one of the preceding claims, wherein the cumulative slippage is a sum of difference values between each of the plurality of charge slippages and each of the plurality of discharge slippages.

**8.** The method as claimed in any one of the preceding claims, wherein each of the plurality of charge slippages is an amount of change between a charge profile of a first charge cycle and a charge profile of a subsequent cycle of the first charge cycle, and
each of the plurality of discharge slippages is an amount of change between a discharge profile of a first discharge cycle and a discharge profile of a subsequent cycle of the first discharge cycle.

**9.** The method as claimed in any one of the preceding claims, wherein the calculating (1020) the correlation comprises:
calculating a correlation between the cumulative slippage and a deterioration tendency of the target battery (12).

**10.** The method as claimed in any one of the preceding claims, wherein the calculating (1020) the correlation comprises:
calculating a correlation between the cumulative slippage and a performance life of the target battery (12) using a linear regression model technique.

**11.** The method as claimed in any one of the preceding claims, wherein the predicting (1030) the life of the target battery comprises:
predicting a state of health, SOH, of the target battery (12) based on charge and discharge cycles based on the cumulative slippage.

**12.** A device for predicting a life of a battery (16), comprising:

a data generation module (120) configured to generate cumulative slippage data based on life assessment data of a target battery (12);
a slippage life analysis module (140) configured to calculate a correlation between the cumulative slippage and a performance life of the target battery (12); and
a life prediction module (160) configured to predict a life of the target battery (12) based on the correlation.

**13.** The device as claimed in claim 12, wherein the life assessment data comprises voltage profile data on a capacity of the target battery (12) in a range of 0 to 250 charge/discharge cycles.

**14.** The device as claimed in claim 12 or 13, wherein the data generation module (120) comprises:

a calculate cumulative capacity profile, CCP, calculation module (122) configured to CCP data based on the life assessment data; and
a slippage calculation module (124) configured to calculate a cumulative slippage based on the CCP data.

**15.** The device as claimed in claim 14, wherein the CCP calculation module (122) is configured to calculate the CCP data based on a plurality of charge profiles and a plurality of discharge profiles extracted from the life assessment data.

1

12 14 16

| BATTERY | LIFE ASSESSMENT DATA COLLECTION DEVICE | LIFE PREDICTION DEVICE |

# FIG. 1

INFORMATION PROCESSING SYSTEM <u>200</u>

/210
MEMORY

/240
INPUT/OUTPUT INTERFACE

/220
PROCESSOR

/230
COMMUNICATION MODULE

# FIG. 2

16

FIG. 3

<u>120</u>

| CCP CALCULATION MODULE |
| <u>122</u> |

| SLIPPAGE CALCULATION MODULE |
| <u>124</u> |

# FIG. 4

FIG. 5

FIG. 6

FIG. 7A

FIG. 7B

FIG. 8

FIG. 9

1000

1010

CALCULATING CUMULATIVE SLIPPAGE DATA BASED ON LIFE
ASSESSMENT DATA OF A TARGET BATTERY

1020

CALCULATING A CORRELATION BETWEEN THE CUMULATIVE SLIPPAGE
AND THE PERFORMANCE LIFE OF THE TARGET BATTERY

1030

PREDICTING THE LIFE OF THE TARGET BATTERY BASED
ON THE CORRELATION

FIG. 10

| | Europäisches Patentamt<br>European Patent Office<br>Office européen des brevets | **EUROPEAN SEARCH REPORT** | **Application Number**<br>EP 25 20 1423 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Anonymous: "Coulombic Efficiency Blog Series: Part 4 of 5 - Charge Endpoint Capacity Slippage - NOVONIX", ,<br>11 August 2022 (2022-08-11), XP093358951,<br>Retrieved from the Internet:<br>URL:https://www.novonixgroup.com/news/coulombic-efficiency-blog-series-part-4-of-5-charge-endpoint-capacity-slippage/<br>[retrieved on 2026-01-28] | 1-4,9-15 | INV.<br>G01R31/392<br><br>ADD.<br>G01R31/367 |
| A | * the whole document * | 5-8 | |
| X | SMITH A. J. ET AL: "Interpreting High Precision Coulometry Results on Li-ion Cells",<br>JOURNAL OF THE ELECTROCHEMICAL SOCIETY,<br>15 August 2011 (2011-08-15), pages A1136-A1142, XP055882242,<br>ISSN: 0013-4651, DOI: 10.1149/1.3625232<br>Retrieved from the Internet:<br>URL:https://iopscience.iop.org/article/10.1149/1.3625232/pdf<br>[retrieved on 2026-01-28] | 1,12 | |
| A | * abstract; figure 5 *<br>* page A1138, right-hand column, last line, page A1139, left-hand column, line 3 * | 2-11,<br>13-15 | **TECHNICAL FIELDS SEARCHED (IPC)**<br><br>G01R |
| A | MARCO-TULIO FONSECA RODRIGUES: "Coulombic efficiency and capacity retention are not universal descriptors of cell aging",<br>ARXIV.ORG, CORNELL UNIVERSITY LIBRARY, 201 OLIN LIBRARY CORNELL UNIVERSITY ITHACA, NY 14853,<br>15 September 2022 (2022-09-15),<br>XP091318807,<br>* page 11, lines 1-8; figures 3a,3b * | 4,15 | |

-/--

The present search report has been drawn up for all claims

| Place of search | Date of completion of the search | Examiner |
|---|---|---|
| Munich | 29 January 2026 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

**EUROPEAN SEARCH REPORT**

Application Number

EP 25 20 1423

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | XIA JIAN ET AL: "Variation of coulombic efficiency versus upper cutoff potential of Li-ion cells tested with aggressive protocols", JOURNAL OF POWER SOURCES, ELSEVIER, AMSTERDAM, NL, vol. 306, 17 December 2015 (2015-12-17), pages 233-240, XP029399129, ISSN: 0378-7753, DOI: 10.1016/J.JPOWSOUR.2015.12.013 * the whole document * | 1-15 | |

-----

TECHNICAL FIELDS
SEARCHED      (IPC)

The present search report has been drawn up for all claims

| Place of search | Date of completion of the search | Examiner |
|---|---|---|
| Munich | 29 January 2026 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)